# EUROPEAN PATENT SPECIFICATION

(11) **EP 4 028 574 B1**
(45) Date of publication and mention of the grant of the patent: **16.07.2025**
(21) Application number: 20776052.1
(22) Date of filing: 11.09.2020
(51) Int. Cl.: C23C 16/453, C23C 16/455, C23C 16/54, C21D 9/46, C21D 9/573, C22F 1/04, C22F 1/00, C22F 1/047, C22F 1/053

(54) **SURFACE ENGINEERED METAL SUBSTRATE AND RELATED METHOD**
OBERFLÄCHENVERÄNDERTES METALLSUBSTRAT UND ZUGEHÖRIGES VERFAHREN
SUBSTRAT MÉTALLIQUE MODIFIÉ EN SURFACE ET PROCÉDÉ ASSOCIÉ

(30) Priority: 12.09.2019 US 201962899269 P
(43) Date of publication of application: 20.07.2022
(73) Proprietor: Novelis Inc., Atlanta, GA 30326 (US)
(72) Inventor: BECK, Thomas J., Kennesaw, Georgia 30144 (US); HUNTER, John Anthony, Kennesaw, Georgia 30144 (US); VEGA, Luis Fanor, Kennesaw, Georgia 30144 (US); MACFARLANE, Theresa Elizabeth, Kennesaw, Georgia 30144 (US); CUMARANATUNGE, Lasitha, Kennesaw, Georgia 30144 (US); TRUICA-MARASESCU, Florina, Kingston, Ontario K7K 3B5 (CA); JONES, Robert, Maple Road RR1 Odessa, Ontario K0H 2H0 (CA); CHVEDOV, Dmitri, Kennesaw, Georgia 30144 (US)
(74) Representative: Weickmann & Weickmann PartmbB
(86) International application number: PCT/US2020/050410
(87) International publication number: WO 2021/050876

(56) References cited:
- EP-A2- 2 194 162
- DE-A1- 19 905 697
- US-A1- 2009 233 000
- US-B1- 6 214 473

## Description

### FIELD

This disclosure relates to the fields of material science, material chemistry, surface science, metallurgy, aluminum alloys, and related fields. More specifically, the disclosure relates to surface engineered metal substrates and methods for their preparation and use.

### BACKGROUND

Certain metals and alloys produced for use in consumer applications require a surface preparation to alleviate downstream processing and lifetime problems, including coating adhesion, corrosion, bond durability, and food safety issues. These surface preparations are often accomplished using wet chemical deposition techniques (e.g., chemical baths, sprays, and roll coaters). However, such surface preparation processes create safety concerns, require costly equipment and maintenance, and produce inconsistent application results.

DE 199 05 697 A1 discloses a method for generating adhesive SiOₓ layers on surfaces of metal, ceramics, glass and plastics for bonding the substrate with glues, lacquers and other polymer coatings.

EP 2 194 162 A2 is directed to the use of a layer on a surface of a substrate, wherein the layer is produced by a flame pyrolysis process and wherein phosphorus and silicon containing reaction products are deposited on the surface of the substrate in at least one layer for protecting the substrate against corrosion.

### SUMMARY

Covered embodiments of the invention are defined by the claims, not this summary. This summary is a high-level overview of various aspects of the invention and introduces some of the concepts that are further described in the Detailed Description section below. This summary is not intended to identify key or essential features of the claimed subject matter, nor is it intended to be used in isolation to determine the scope of the claimed subject matter. The subject matter should be understood by reference to appropriate portions of the entire specification, any or all drawings and each claim.

Provided herein are surface engineering systems, methods for engineering at least a surface of a metal substrate, and surface engineered metal substrates. A disclosed surface engineering system includes a gas mixture of an oxidizer and a combustible gas, a chemical precursor having a silicon-containing compound, a phosphorus-containing compound, or a combination thereof, and a chemical additive, wherein the chemical precursor and the chemical additive are gaseous, are liquids that are vaporized or aerosolized, or are solids that are sublimed. The combustible gas can be natural gas, methane, propane, butane, and/or any other suitable combustible material. Optionally, the oxidizer is air. The oxidizer and the combustible gas can be present in the gas mixture in a molar ratio of from 1:1 to 10:1 (e.g., from 6:1 to 10:1). The silicon-containing compound optionally can comprise hexamethyldisiloxane (HMDSO), tetramethylsilane (TMS), tetraethoxysilane (TEOS), triethoxysilane, N-sec-butyl(trimethylsilyl)amine, 1,3-diethyl-1,1,3,3,tetramethyldisilazane, methylsilane, pentamethyldisilane, tetraethylsilane, tetramethyldisilane, or any other suitable organosilicon compound. The phosphorus-containing compound can comprise vinylphosphonic acid, trimethyl phosphate, dimethyl phosphate, triethyl phosphate, triisopropyl phosphate, tris(dimethylamino)phosphine, phosphorous pentoxide, or a combination thereof. The chemical additive can comprise adhesion promoters, corrosion inhibitors, aesthetic dopants, a coupling agent, an antimicrobial agent, or the like, or any combination thereof.

Provided herein are methods of engineering a metal substrate surface comprising combining an oxidizer and a combustible gas to form a gas mixture, igniting the gas mixture to form a premixed laminar flame, feeding a chemical precursor including a silicon-containing compound, and a chemical additive into the premixed laminar flame to form a surface engineering flame, and directing the surface engineering flame onto a surface of a metal substrate to deposit a thin film onto the surface of the metal substrate. The chemical precursor and/or the chemical additive can optionally be gaseous or a liquid that is vaporized or aerosolized.

The silicon-containing compound can comprise hexamethyldisiloxane (HMDSO), tetramethylsilane (TMS), tetraethoxysilane (TEOS), triethoxysilane, N-sec-butyl(trimethylsilyl)amine, 1,3-diethyl-1,1,3,3,tetramethyldisilazane, methylsilane, pentamethyldisilane, tetraethylsilane, tetramethyldisilane, and/or any other suitable silicon compound, including organosilicon compounds. The chemical additive can comprise adhesion promoters, corrosion inhibitors, coupling agents, antimicrobial agents, or the like, or any combination thereof.

The method can further include cleaning the surface of the metal substrate prior to the directing step (i.e., prior to depositing the thin film onto the surface of the metal substrate). In some cases, the cleaning can be performed by directing a flame onto the surface of the metal substrate. Optionally, the flame can be the premixed laminar flame. In some cases, the cleaning can be performed using a chemical etching process, an electrolytic cleaning process, and/or an ultrasonic cleaning process. The chemical precursor and/or the chemical additive can be fed into the premixed laminar flame at a flow rate of from about 500 mL/min to about 5000 mL/min. Optionally, the surface of the metal substrate is maintained at a distance from a burner of the surface engineering flame, such as from about 8 mm to about 40 mm. The method can further include electrolytically oxidizing the surface of the metal substrate prior to the directing step.

Further provided herein is a surface engineered metal substrate having a surface and a thin film, wherein the thin film comprises a silicon-containing compound and a chemical additive (e.g., an adhesion promoter, a corrosion inhibitor, a coupling agent, an antimicrobial agent, or a mixture thereof). Optionally, the thin film is adhered to at least the first surface of the metal substrate. Optionally, the surface engineered metal substrate further includes a thin electrolytic oxidized layer.

The surface engineered metal substrate is a 7xxx series aluminum alloy in an F temper. In these cases, the thin film is a dense amorphous silicate thin film in contact with greater than 80% of the surface or the surface engineered metal substrate.

Further aspects, objects, and advantages will become apparent upon consideration of the detailed description of non-limiting examples that follow.

### BRIEF DESCRIPTION OF THE FIGURES

Figure 1 is a schematic of a surface engineering method described herein.
Figure 2 is a schematic of a surface engineering method described herein according to an example described herein.
Figure 3A shows a digital image of a surface engineered and zinc phosphated exemplary aluminum alloy. Figure 3B shows a digital image of a zinc phosphated aluminum alloy after a non-optimized thin film deposition.
Figure 4A shows a digital image of a surface engineered, zinc phosphated, and electrocoated exemplary aluminum alloy. Figure 4B shows a digital image of a zinc phosphated and electrocoated aluminum alloy after a non-optimized thin film deposition.
Figure 5A shows two exemplary aluminum alloy substrates bonded, tested in a bond durability test, and separated for analysis. Figure 5B shows two exemplary aluminum alloy substrates bonded, tested in a bond durability test, and separated for analysis.
Figure 6A shows two exemplary aluminum alloy substrates bonded, tested in a bond durability test, and separated for analysis. Figure 6B shows two exemplary aluminum alloy substrates bonded, tested in a bond durability test, and separated for analysis.
Figure 7 is a graph of resistance spot welding (RSW) data of a non-surface engineered aluminum alloy.
Figure 8 is a graph of RSW data of an exemplary aluminum alloy prepared according to methods described herein.
Figure 9 is a graph of RSW data of an exemplary aluminum alloy prepared according to methods described herein. RSW parameters were optimized for the exemplary aluminum alloy.
Figure 10 is a digital image of a weld expulsion.
Figure 11 is a graph showing the average coefficient of friction results from a cylinder-on-flat friction test of an exemplary aluminum alloy prepared according to methods described herein ("surface engineered") and a comparative aluminum alloy ("etched").
Figure 12 is a graph showing the average cycles to failure results from a cylinder-on-flat friction test of an exemplary aluminum alloy prepared according to methods described herein ("surface engineered") and a comparative aluminum alloy ("etched").

### DETAILED DESCRIPTION

Described herein are methods to engineer a metal substrate (e.g., an aluminum alloy) surface using a dry chemical deposition technique and the resulting engineered metal substrates. More particularly, disclosed are chemical thin films deposited via flame pyrolysis. The thin films are deposited using a surface engineering system, which includes a gas mixture, including an oxidizer and a combustible gas, a chemical precursor gas, and a chemical additive gas. The chemical precursor gas can be a mixture of compounds capable of imparting various surface characteristics to the metal substrate to engineer the surface of the metal substrate.

### Definitions and Descriptions:

The terms "invention," "the invention," "this invention," and "the present invention" used herein are intended to refer broadly to all of the subject matter of this patent application and the claims below. Statements containing these terms should be understood not to limit the subject matter described herein or to limit the meaning or scope of the patent claims below.

In this description, reference is made to alloys identified by aluminum industry designations, such as "series" or "AA6xxx." For an understanding of the number designation system most commonly used in naming and identifying aluminum and its alloys, see "International Alloy Designations and Chemical Composition Limits for Wrought Aluminum and Wrought Aluminum Alloys" or "Registration Record of Aluminum Association Alloy Designations and Chemical Compositions Limits for Aluminum Alloys in the Form of Castings and Ingot," both published by The Aluminum Association.

As used herein, the meaning of "a," "an," or "the" includes singular and plural references unless the context clearly dictates otherwise.

As used herein, the meaning of "room temperature" can include a temperature of from about 15 °C to about 30 °C, for example about 15 °C, about 16 °C, about 17 °C, about 18 °C, about 19 °C, about 20 °C, about 21 °C, about 22 °C, about 23 °C, about 24 °C, about 25 °C, about 26 °C, about 27 °C, about 28 °C, about 29 °C, or about 30 °C.

Reference is made in this application to alloy temper or condition. For an understanding of the alloy temper descriptions most commonly used, see "American National Standards (ANSI) H35 on Alloy and Temper Designation Systems." An F condition or temper refers to an aluminum alloy as fabricated. A W condition or temper refers to an aluminum alloy solution heat treated at a temperature greater than a solvus temperature of the aluminum alloy and then quenched. An O condition or temper refers to an aluminum alloy after annealing. A T1 condition or temper refers to an aluminum alloy cooled from hot working and naturally aged (e.g., at room temperature). A T2 condition or temper refers to an aluminum alloy cooled from hot working, cold worked and naturally aged. A T3 condition or temper refers to an aluminum alloy solution heat treated, cold worked, and naturally aged. A T4 condition or temper refers to an aluminum alloy solution heat treated and naturally aged. A T5 condition or temper refers to an aluminum alloy cooled from hot working and artificially aged (at elevated temperatures). A T6 condition or temper refers to an aluminum alloy solution heat treated and artificially aged. A T7 condition or temper refers to an aluminum alloy solution heat treated and artificially overaged. A T8x condition or temper refers to an aluminum alloy solution heat treated, cold worked, and artificially aged. A T9 condition or temper refers to an aluminum alloy solution heat treated, artificially aged, and cold worked. A W condition or temper refers to an aluminum alloy after solution heat treatment.

As used herein, a plate generally has a thickness of greater than about 15 mm. For example, a plate may refer to an aluminum product having a thickness of greater than about 15 mm, greater than about 20 mm, greater than about 25 mm, greater than about 30 mm, greater than about 35 mm, greater than about 40 mm, greater than about 45 mm, greater than about 50 mm, greater than about 100 mm, or up to about 300 mm.

As used herein, a shate (also referred to as a sheet plate) generally has a thickness of from about 4 mm to about 15 mm. For example, a shate may have a thickness of about 4 mm, about 5 mm, about 6 mm, about 7 mm, about 8 mm, about 9 mm, about 10 mm, about 11 mm, about 12 mm, about 13 mm, about 14 mm, or about 15 mm.

As used herein, a sheet generally refers to an aluminum product having a thickness of less than about 4 mm. For example, a sheet may have a thickness of less than about 4 mm, less than about 3 mm, less than about 2 mm, less than about 1 mm, less than about 0.5 mm, or less than about 0.3 mm (e.g., about 0.2 mm).

As used herein, a foil generally refers to an aluminum alloy product having a thickness of less than about 0.2 mm, less than about 0.1 mm, less than about 0.09 mm, less than about 0.08 mm, less than about 0.07 mm, less than about 0.06 mm, or less than about 0.05 mm.

The term "and/or" when used in a list of two or more items, means that any one of the listed items can be employed by itself or in combination with any one or more of the listed items. For example, the expression "A and/or B" is intended to mean either or both of A and B, i.e., A alone, B alone, or A and B in combination. The expression "A, B and/or C" is intended to mean A alone, B alone, C alone, A and B in combination, A and C in combination, B and C in combination or A, B, and C in combination.

As used herein, terms such as "cast metal product," "cast product," "cast aluminum alloy product," and the like are interchangeable and refer to a product produced by direct chill casting (including direct chill co-casting) or semi-continuous casting, continuous casting (including, for example, by use of a twin belt caster, a twin roll caster, a twin block caster, or any other continuous caster), electromagnetic casting, hot top casting, or any other casting method.

As used herein, the term "surface" refers to the portion of the metal article that extends from the exterior face of the metal article into an interior of the metal article to a depth of up to about 5 µm. Optionally, the surface refers to the portion of the metal article that extends into the interior of the metal article to a depth of about 0.01 µm, about 0.02 µm, about 0.03 µm, about 0.04 µm, about 0.05 µm, about 0.06 µm, about 0.07 µm, about 0.08 µm, about 0.09 µm, about 0.1 µm, about 0.15 µm, about 0.2 µm, about 0.25 µm, about 0.3 µm, about 0.35 µm, about 0.4 µm, about 0.45 µm, about 0.5 µm, about 0.55 µm, about 0.6 µm, about 0.65 µm, about 0.7 µm, about 0.75 µm, about 0.8 µm, about 0.85 µm, about 0.9 µm, about 0.95 µm, about 1.0 µm, about 1.5 µm, about 2.0 µm, about 2.5 µm, about 3.0 µm, about 3.5 µm, about 4.0 µm, about 4.5 µm, or about 5.0 µm, or anywhere in between. In some examples, the surface extends from the surface to a depth of about 2.0 µm within the interior of the metal article. In some aspects, the surface can extend from any exterior surface of the metal article. For example, the surface can extend from a first side of the metal article (e.g., a top surface of a metal sheet), a second side of the metal article (e.g., a bottom surface of a metal sheet), a third side of the metal article (e.g., a first edge of a metal sheet), or a fourth side of the metal article (e.g., a second edge of a metal sheet).

All ranges disclosed herein are to be understood to encompass any and all subranges subsumed therein. For example, a stated range of "1 to 10" should be considered to include any and all subranges between (and inclusive of) the minimum value of 1 and the maximum value of 10; that is, all subranges beginning with a minimum value of 1 or more, e.g., 1 to 6.1, and ending with a maximum value of 10 or less, e.g., 5.5 to 10.

### Surface Engineering Systems (not according to the invention):

Described herein are surface engineering systems that can be used to deposit a silicon-containing film, a phosphorus-containing film, and/or a silicon-phosphorus-containing film onto a surface of a metal substrate using a flame pyrolysis reaction. The surface engineering systems described herein include a gas mixture, a chemical precursor, and a chemical additive. The chemical precursor and the chemical additive are gaseous in the surface engineering systems.

The gas mixture for use in the surface engineering systems includes an oxidizer and a combustible gas. The oxidizer serves as the oxygen source and can be, for example, air or oxygen. The combustible gas can include an alkane, an alkene, an alkyne, an alicyclic compound (e.g., a cycloalkane, a cycloalkene, or a cycloalkyne), a ketone, an aromatic compound (e.g., a carbon-based aromatic compound or a heteroatom-containing aromatic compound), an alcohol, an ether, an amine, an ester, an aldehyde, a saturated or unsaturated heterocyclic compound, any combination thereof, or any suitable combustion fuel source. Optionally, the combustible gas can be natural gas, methane, propane, or butane. The oxidizer and the combustible gas can be present in the gas mixture in a molar ratio of from about 1:1 to about 10:1 (e.g., from about 3:1 to about 9:1 or from about 6:1 to about 10:1). For example, the molar ratio of the oxidizer and the combustible gas can be about 1:1, about 1.5:1, about 2:1, about 2.5:1, about 3:1, about 3.5:1, about 4:1, about 4.5:1, about 5:1, about 5.5:1, about 6:1, about 6.5:1, about 7:1, about 7.5:1, about 8:1, about 8.5:1, about 9:1, about 9.5:1, or about 10:1, or anywhere in between.

The surface engineering systems described herein also include a chemical precursor. The chemical precursor is gaseous and can be prepared, for example, by vaporizing a liquid chemical precursor (e.g., by vaporizing a chemical precursor that is liquid at room temperature, by vaporizing a solid chemical precursor that is dissolved or dispersed in a solvent, or by sublimating a solid chemical precursor) using, for example, a bubbling system or a controlled evaporator mixer or by aerosolizing a chemical precursor that is liquid at room temperature. The chemical precursor includes a silicon-containing compound, a phosphorus-containing compound, or a combination thereof. In some examples, the silicon-containing compound can be silane, disilane, trisilane, tetrasilane, pentasilane, a siloxane, a silanol, chlorosilane, tetraethyl orthosilicate, silicon tetrachloride, dichlorosilane, trichlorosilane, difluorosilane, vinylsilane, dimethyldichlorosilane, hexamethyldisiloxane (HMDSO), methylsilane, dimethylsilane, trimethylsilane, tetramethylsilane (TMS), tetramethyldisilane, tetraethoxysilane (TEOS), triethoxysilane, N-sec-butyl(trimethylsilyl)amine, 1,3-diethyl-1,1,3,3,tetramethyldisilazane, pentamethyldisilane, tetraethylsilane, or any other suitable silicon-containing compound, including organic silicon-containing compounds and inorganic silicon-containing compounds. In some non-limiting examples, the phosphorus-containing compound can include vinylphosphonic acid, trimethyl phosphate, dimethyl phosphate, triethyl phosphate, triisopropyl phosphate, tris(dimethylamino)phosphine, phosphorous pentoxide, or any other suitable phosphorus-containing compound, including organic phosphorus-containing compounds and inorganic phosphorus-containing compounds.

Optionally, the chemical precursor can include a titanium-containing compound, a cobalt-containing compound, a chromium-containing compound, a molybdenum-containing compound, a nickel-containing compound, a copper-containing compound, a zirconium-containing compound, a tantalum-containing compound, a cerium-containing compound, a zinc-containing compound, or a tungsten-containing compound. One of more of these compounds can be used as the chemical precursor alone or in combination with a silicon-containing compound, and/or a phosphorus-containing compound.

A chemical additive can also be present in the surface engineering system. Optionally, the chemical additive can be gaseous or can be prepared, for example, by vaporizing a liquid chemical additive (e.g., by vaporizing a chemical additive that is liquid at room temperature or by vaporizing a solid chemical additive that is dissolved or dispersed in a solvent) or by aerosolizing a liquid chemical additive. In some cases, the chemical additive can be a liquid chemical additive that is vaporized using, for example, a bubbler system or a controlled evaporator mixer (CEM). In certain cases, the chemical additive can be a solid chemical additive that is sublimed to provide a gaseous chemical additive.

The chemical additive can be chosen according to the desired reaction product and surface properties for the metal substrate. Suitable chemical additives include, for example, adhesion promoters and/or corrosion inhibitors. Optionally, the chemical additives include chromates, molybdates, vanadates, antimonites, arsenates, tungstates, alumina nanoparticles, silica nanoparticles, chloride scavengers, or combinations thereof. Other optional dopants for the chemical additive source can include photocatalytic oxides (e.g., to provide thin functional films for airborne contamination remediation in air filtration systems), ultraviolet (UV) light absorbing compounds (e.g., to provide photovoltaic applications or water heating applications), high temperature lubricants (e.g., to impart dry and/or powder based lubricants), dielectric materials (e.g., to provide capacitive films), coupling agents (e.g., to add organic and/or polymeric films), switchable glazes (e.g., photochromic materials for eyewear and windows), reflective materials (e.g., for thermal management), anti-reflective coating materials (e.g., for automotive applications or museum glass), conductive materials (e.g., for photovoltaic cells), scratch resistant materials, antimicrobial agents (e.g., for fin stock for use in heating, ventilation, and air conditioning (HVAC) systems), and/or aesthetic dopants (e.g., to impart visual and/or other sensory characteristics to the surface of the metal substrate).

For example, photocatalytic oxides can include titanium dioxide (TiO₂), zinc oxide (ZnO), tin oxide (SnO₂), and cerium oxide (CeO₂). UV light absorbing compounds can include TiO₂, iron oxides (e.g., FeO and/or Fe₂O₃), and chromium oxide (Cr₂O₃). High temperature lubricants can include phosphate esters, silicones, silicates, polyphenol ethers, and perfluoropolyalkyl ethers. Dielectric materials can include ceramics, metal oxides, and glasses. Coupling agents can include silicon based coupling agents. Switchable glaze materials can include tungsten oxides (WOₓ) and molybdenum oxides (MoOₓ). Reflective materials can include gold, silver, chrome, and other high-reflectivity metals. Anti-reflective materials can include silicon dioxide (SiO₂). Conductive materials can include silver, gold, ZnO, and indium tin oxide (ITO). Scratch resistant materials can include zirconium oxide (ZrO₂). Antimicrobial agents can include silver nanoparticles, zinc-doped glasses, and zeolites of silver, copper, zinc, and/or tin.

### Surface Engineering Methods:

Described herein are methods of engineering surfaces of metal substrates by depositing films using a flame pyrolysis reaction. The flame pyrolysis reaction is performed by combining a gas mixture as described above (i.e., an oxidizer and a combustible gas), a chemical precursor source, and at least one chemical additive source. Ignition of a gas mixture (e.g., a fuel), a chemical precursor, and a chemical additive can provide a desired reaction product. For example, ignition of a fuel, chemical precursor, and chemical additive mixture provides a flame that can decompose the fuel, chemical precursor, and chemical additive compounds, providing a solid reaction product and gaseous waste products. The desired reaction product deposits onto a metal substrate in contact with the flame. Suitable metal substrates for use in the disclosed methods are an aluminum alloy. The metal substrate may include monolithic materials, as well as non-monolithic materials such as roll-bonded materials, clad materials, composite materials (such as but not limited to carbon fiber-containing materials), or various other materials. In some examples, the metal substrate is a metal coil, a metal strip, a metal plate, a metal sheet, a metal billet, a metal ingot, or the like.

The metal substrate includes an aluminum alloy. The aluminum alloy includes a 1xxx series aluminum alloy, a 2xxx series aluminum alloy, a 3xxx series aluminum alloy, a 4xxx series aluminum alloy, a 5xxx series aluminum alloy, a 6xxx series aluminum alloy, a 7xxx series aluminum alloy, or an 8xxx series aluminum alloy. The aluminum alloy is provided in an as-fabricated condition, i.e, an F temper.

Optionally, the aluminum alloy can be a 1xxx series aluminum alloy according to one of the following aluminum alloy designations: AA1100, AA1100A, AA1200, AA1200A, AA1300, AA1110, AA1120, AA1230, AA1230A, AA1235, AA1435, AA1145, AA1345, AA1445, AA1150, AA1350, AA1350A, AA1450, AA1370, AA1275, AA1185, AA1285, AA1385, AA1188, AA1190, AA1290, AA1193, AA1198, or AA1199.

Optionally, the aluminum alloy can be a 2xxx series aluminum alloy according to one of the following aluminum alloy designations: AA2001, A2002, AA2004, AA2005, AA2006, AA2007, AA2007A, AA2007B, AA2008, AA2009, AA2010, AA2011, AA2011A, AA2111, AA2111A, AA2111B, AA2012, AA2013, AA2014, AA2014A, AA2214, AA2015, AA2016, AA2017, AA2017A, AA2117, AA2018, AA2218, AA2618, AA2618A, AA2219, AA2319, AA2419, AA2519, AA2021, AA2022, AA2023, AA2024, AA2024A, AA2124, AA2224, AA2224A, AA2324, AA2424, AA2524, AA2624, AA2724, AA2824, AA2025, AA2026, AA2027, AA2028, AA2028A, AA2028B, AA2028C, AA2029, AA2030, AA2031, AA2032, AA2034, AA2036, AA2037, AA2038, AA2039, AA2139, AA2040, AA2041, AA2044, AA2045, AA2050, AA2055, AA2056, AA2060, AA2065, AA2070, AA2076, AA2090, AA2091, AA2094, AA2095, AA2195, AA2295, AA2196, AA2296, AA2097, AA2197, AA2297, AA2397, AA2098, AA2198, AA2099, or AA2199.

Optionally, the aluminum alloy can be a 3xxx series aluminum alloy according to one of the following aluminum alloy designations: AA3002, AA3102, AA3003, AA3103, AA3103A, AA3103B, AA3203, AA3403, AA3004, AA3004A, AA3104, AA3204, AA3304, AA3005, AA3005A, AA3105, AA3105A, AA3105B, AA3007, AA3107, AA3207, AA3207A, AA3307, AA3009, AA3010, AA3110, AA3011, AA3012, AA3012A, AA3013, AA3014, AA3015, AA3016, AA3017, AA3019, AA3020, AA3021, AA3025, AA3026, AA3030, AA3130, or AA3065.

Optionally, the aluminum alloy can be a 4xxx series aluminum alloy according to one of the following aluminum alloy designations: AA4004, AA4104, AA4006, AA4007, AA4008, AA4009, AA4010, AA4013, AA4014, AA4015, AA4015A, AA4115, AA4016, AA4017, AA4018, AA4019, AA4020, AA4021, AA4026, AA4032, AA4043, AA4043A, AA4143, AA4343, AA4643, AA4943, AA4044, AA4045, AA4145, AA4145A, AA4046, AA4047, AA4047A, or AA4147.

Optionally, the aluminum alloy can be a 5xxx series aluminum alloy according to one of the following aluminum alloy designations: AA5005, AA5005A, AA5205, AA5305, AA5505, AA5605, AA5006, AA5106, AA5010, AA5110, AA5110A, AA5210, AA5310, AA5016, AA5017, AA5018, AA5018A, AA5019, AA5019A, AA5119, AA5119A, AA5021, AA5022, AA5023, AA5024, AA5026, AA5027, AA5028, AA5040, AA5140, AA5041, AA5042, AA5043, AA5049, AA5149, AA5249, AA5349, AA5449, AA5449A, AA5050, AA5050A, AA5050C, AA5150, AA5051, AA5051A, AA5151, AA5251, AA5251A, AA5351, AA5451, AA5052, AA5252, AA5352, AA5154, AA5154A, AA5154B, AA5154C, AA5254, AA5354, AA5454, AA5554, AA5654, AA5654A, AA5754, AA5854, AA5954, AA5056, AA5356, AA5356A, AA5456, AA5456A, AA5456B, AA5556, AA5556A, AA5556B, AA5556C, AA5257, AA5457, AA5557, AA5657, AA5058, AA5059, AA5070, AA5180, AA5180A, AA5082, AA5182, AA5083, AA5183, AA5183A, AA5283, AA5283A, AA5283B, AA5383, AA5483, AA5086, AA5186, AA5087, AA5187, or AA5088.

Optionally, the aluminum alloy can be a 6xxx series aluminum alloy according to one of the following aluminum alloy designations: AA6101, AA6101A, AA6101B, AA6201, AA6201A, AA6401, AA6501, AA6002, AA6003, AA6103, AA6005, AA6005A, AA6005B, AA6005C, AA6105, AA6205, AA6305, AA6006, AA6106, AA6206, AA6306, AA6008, AA6009, AA6010, AA6110, AA6110A, AA6011, AA6111, AA6012, AA6012A, AA6013, AA6113, AA6014, AA6015, AA6016, AA6016A, AA6116, AA6018, AA6019, AA6020, AA6021, AA6022, AA6023, AA6024, AA6025, AA6026, AA6027, AA6028, AA6031, AA6032, AA6033, AA6040, AA6041, AA6042, AA6043, AA6151, AA6351, AA6351A, AA6451, AA6951, AA6053, AA6055, AA6056, AA6156, AA6060, AA6160, AA6260, AA6360, AA6460, AA6460B, AA6560, AA6660, AA6061, AA6061A, AA6261, AA6361, AA6162, AA6262, AA6262A, AA6063, AA6063A, AA6463, AA6463A, AA6763, A6963, AA6064, AA6064A, AA6065, AA6066, AA6068, AA6069, AA6070, AA6081, AA6181, AA6181A, AA6082, AA6082A, AA6182, AA6091, or AA6092.

Optionally, the aluminum alloy can be a 7xxx series aluminum alloy according to one of the following aluminum alloy designations: AA7011, AA7019, AA7020, AA7021, AA7039, AA7072, AA7075, AA7085, AA7108, AA7108A, AA7015, AA7017, AA7018, AA7019A, AA7024, AA7025, AA7028, AA7030, AA7031, AA7033, AA7035, AA7035A, AA7046, AA7046A, AA7003, AA7004, AA7005, AA7009, AA7010, AA7011, AA7012, AA7014, AA7016, AA7116, AA7122, AA7023, AA7026, AA7029, AA7129, AA7229, AA7032, AA7033, AA7034, AA7036, AA7136, AA7037, AA7040, AA7140, AA7041, AA7049, AA7049A, AA7149, AA7249, AA7349, AA7449, AA7050, AA7050A, AA7150, AA7250, AA7055, AA7155, AA7255, AA7056, AA7060, AA7064, AA7065, AA7068, AA7168, AA7175, AA7475, AA7076, AA7178, AA7278, AA7278A, AA7081, AA7181, AA7185, AA7090, AA7093, AA7095, or AA7099.

Optionally, the aluminum alloy can be an 8xxx series aluminum alloy according to one of the following aluminum alloy designations: AA8005, AA8006, AA8007, AA8008, AA8010, AA8011, AA8011A, AA8111, AA8211, AA8112, AA8014, AA8015, AA8016, AA8017, AA8018, AA8019, AA8021, AA8021A, AA8021B, AA8022, AA8023, AA8024, AA8025, AA8026, AA8030, AA8130, AA8040, AA8050, AA8150, AA8076, AA8076A, AA8176, AA8077, AA8177, AA8079, AA8090, AA8091, or AA8093.

The distance between the metal substrate and the flame (referred to as a "frontal distance") and flow rate of the fuel, precursor and additive gas mixture can dictate film morphology and will be described in detail hereafter.

### Optional Cleaning

The surface engineering process described herein can optionally include a step of cleaning the surface of the metal substrate prior to applying the thin film. The cleaning step can include applying a cleaner to a surface of a metal substrate, such as a metal sheet or coil surface. The cleaner removes residual contaminants that may include oils, oxides, or the like (e.g., residual oils or loosely adhering oxides) from the metal substrate surface. **In** some aspects, cleaning the surface can be performed in a substantially horizontal configuration, a substantially vertical configuration, any configuration in between, any further suitable configuration, or any combination thereof.

Optionally, cleaning can be performed as part of a surface engineering method. **In** some examples, exposure to non-depositing flames, such as the premixed laminar flame, can be used to remove carbon-based contaminants residual from a production process (e.g., mill oils, lubricants or contaminants from handling) and functionalize and/or oxidize the metal substrate surface prior to thin film deposition. In these cases, the cleaning is performed by directing a flame (e.g., the premixed laminar flame) onto a surface of the metal substrate. The flame cleaning step can provide a metal substrate having a hydrophilic surface.

In some non-limiting examples, exposure to non-depositing flames, such as the premixed laminar flame, can be used to increase surface energy of the metal substrate. Increased surface energy can improve adhesion properties in wet coatings that can be applied in downstream and end-user applications.

Optionally, the cleaning can be performed using a solvent or a mixture of solvents, such as hexane, ethanol, acetone, and/or combinations of these.

In some examples, a chemical etching process can be used for cleaning the surface of the metal substrate. The surface of the metal substrate can be etched using a chemical etch procedure such as an acid etch procedure (i.e., an etching procedure that includes an acid solution having a pH of less than 7), an alkaline etch procedure (i.e., an etching procedure that includes a basic solution having a pH of greater than 7), or an etch procedure under neutral conditions (i.e., an etching procedure that includes a neutral solution having a pH of 7). The chemical etch procedure prepares the surface to accept the subsequent application of a thin film. Exemplary chemicals for performing the acid etch procedure include sulfuric acid, hydrofluoric acid, nitric acid, phosphoric acid, and combinations of these. Exemplary chemicals for performing the alkaline etch procedure include sodium hydroxide and potassium hydroxide.

Optionally, the cleaning can be performed using an electrolytic cleaning system. Employing electrolytic cleaning can increase the efficacy and speed of a coil-to-coil surface engineering process. Combining an electrolytic cleaning system with the exemplary surface engineering systems described herein can increase a coil-to-coil processing speed to greater than about 100 meters per minute (m/min) in a coil-to-coil finishing line.

Optionally, the cleaning can be performed using ultrasonic agitation. The metal substrate can be immersed in a bath containing an aqueous or non-aqueous solvent (e.g., water, distilled water, demineralized water, deionized water, acids, bases, or any combination thereof) and exposed to the ultrasonic agitation to remove surface contaminants.

### Optional Thin Electrolytic Oxidized Film Application

The processes described herein can optionally include a step of electrolytically oxidizing a surface of the metal substrate prior to applying the surface engineered thin film, such that a thin electrolytic oxidized film can be applied to the metal substrate. Electrolytic oxidation is accomplished by contacting a surface of the metal substrate with an electrolyte solution and flowing an electric current through the electrolyte. A cathode is disposed parallel to the metal substrate surface such that the surface is an anode. **In** some aspects, electrolytically oxidizing the surface can be performed in a horizontal configuration, a vertical configuration, a combination of vertical and horizontal configurations, or any further suitable configuration. Current flow in the electrolyte releases oxygen ions that can migrate to the metal substrate surface and combine with a metal on the surface. For example, the oxygen ions can combine with aluminum on a surface of the metal substrate to form alumina (Al₂O₃).

The electrolyte solution can be applied by rolling the solution onto the metal substrate, by spraying the solution onto the metal substrate, or by immersing the metal substrate or a portion of the metal substrate (e.g., the surface of the metal substrate) in a bath. Optionally, the electrolyte solution can be circulated to ensure a fresh solution is continuously exposed to the surface of the metal substrate. **In** some non-limiting examples, the cathode can be mounted above and/or below the metal substrate; adjacent to a first side and/or adjacent to a second side of the metal substrate; or generally adjacent to the metal substrate, depending on the desired electrolytic oxidation configuration. The dwell time for the electrolytic oxidation can be from about 5 seconds to about 15 seconds, depending on the desired thickness of the electrolytic oxidized film. For example, the dwell time for the electrolytic oxidation can be about 5 seconds, about 6 seconds, about 7 seconds, about 8 seconds, about 9 seconds, about 10 seconds, about 11 seconds, about 12 seconds, about 13 seconds, about 14 seconds, or about 15 seconds. The resulting thickness of the film can be from about 10 nm to about 500 nm thick. For example, the film can be about 10 nm thick, about 20 nm thick, about 30 nm thick, about 40 nm thick, about 50 nm thick, about 60 nm thick, about 70 nm thick, about 80 nm thick, about 90 nm thick, about 100 nm thick, about 110 nm thick, about 120 nm thick, about 130 nm thick, about 140 nm thick, about 150 nm thick, about 160 nm thick, about 170 nm thick, about 180 nm thick, about 190 nm thick, about 200 nm thick, about 210 nm thick, about 220 nm thick, about 230 nm thick, about 240 nm thick, about 250 nm thick, about 260 nm thick, about 270 nm thick, about 280 nm thick, about 290 nm thick, about 300 nm thick, about 310 nm thick, about 320 nm thick, about 330 nm thick, about 340 nm thick, about 350 nm thick, about 360 nm thick, about 370 nm thick, about 380 nm thick, about 390 nm thick, about 400 nm thick, about 410 nm thick, about 420 nm thick, about 430 nm thick, about 440 nm thick, about 450 nm thick, about 460 nm thick, about 470 nm thick, about 480 nm thick, about 490 nm thick, about 500 nm thick, or anywhere in between.

### Surface Engineering

Also disclosed herein are methods for engineering surfaces of aluminum alloy substrates. The method includes steps, as further described below, that result in the depositing of a silicon-containing thin film onto at least one surface of the metal substrate. In some examples, the methods described herein can be a coil-to-coil process for depositing thin films on a metal substrate using flame pyrolysis (e.g., combustion chemical vapor deposition (CCVD) or flame assisted chemical vapor deposition (FA-CVD)).

The method for surface engineering a metal substrate as described herein includes a step of combining an oxidizer and a combustible gas to form a gas mixture. Suitable oxidizers and combustible gases are described above. The gas mixture can then be ignited to form a premixed laminar flame.

A gaseous chemical precursor and a gaseous chemical additive, both as described above, can then be fed into the premixed laminar flame and combusted in the flame to form a surface engineering flame. In some cases, the gaseous chemical precursor and the gaseous chemical additive can be fed simultaneously into the premixed laminar flame. In some cases, the gaseous chemical precursor and the gaseous chemical additive can be fed sequentially into the premixed laminar flame, e.g., to provide a layered functional film. For example, the gaseous chemical precursor can be fed into the premixed laminar flame followed by the gaseous chemical additive or the gaseous chemical additive can be fed into the premixed laminar flame followed by the gaseous chemical precursor, resulting in a layered functionalized film. In some cases, the gaseous chemical precursor and the gaseous chemical additive can be added into the flame in an alternating matter (e.g., a portion of the gaseous chemical precursor can be fed into the premixed laminar flame followed by a portion of the gaseous chemical additive, and the addition cycle can repeat). Thus, single and/or layered functionalized thin films can be prepared.

In some non-limiting examples, the single and/or layered functionalized films can be patterned. For example, a first portion of the metal substrate can be surface engineered as described herein, and a second portion of the metal substrate can be maintained as-fabricated. The single and/or layered functionalized films can be applied to the first portion of the metal substrate in any desired pattern to provide a metal substrate having a patterned engineered surface. Thus, providing a patterned engineered surface can provide localized protection to the metal substrate.

The gas flow rate for the gaseous components added to the premixed laminar flame (e.g., the gaseous chemical precursor, the gaseous chemical additive, or a combination of these) can impact film deposition and, subsequently, the performance properties of the resulting surface engineered substrates. In some cases, the gas flow rate for the gaseous chemical precursor and/or for the gaseous chemical additive can be from about 500 milliliters per minute (mL/min) to about 5000 mL/min (e.g., from about 750 mL/min to about 4000 mL/min, from about 1000 mL/min to about 3500 mL/min, or from about 1500 mL/min to about 3000 mL/min). For example, the gas flow rate for the gaseous chemical precursor and/or for the gaseous chemical additive can be about 500 mL/min, about 600 mL/min, about 700 mL/min, about 800 mL/min, about 900 mL/min, 1000 mL/min, about 1100 mL/min, about 1200 mL/min, about 1300 mL/min, about 1400 mL/min, about 1500 mL/min, about 1600 mL/min, about 1700 mL/min, about 1800 mL/min, about 1900 mL/min, about 2000 mL/min, about 2100 mL/min, about 2200 mL/min, about 2300 mL/min, about 2400 mL/min, about 2500 mL/min, about 2600 mL/min, about 2700 mL/min, about 2800 mL/min, about 2900 mL/min, about 3000 mL/min, about 3100 mL/min, about 3200 mL/min, about 3300 mL/min, about 3400 mL/min, about 3500 mL/min, about 3600 mL/min, about 3700 mL/min, about 3800 mL/min, about 3900 mL/min, about 4000 mL/min, about 4100 mL/min, about 4200 mL/min, about 4300 mL/min, about 4400 mL/min, about 4500 mL/min, about 4600 mL/min, about 4700 mL/min, about 4800 mL/min, about 4900 mL/min, about 5000 mL/min, or anywhere in between.

After the step of feeding the gaseous components into the surface engineering flame, the surface engineering flame can be directed onto a surface of the metal substrate. In some cases, the metal substrate can be passed adjacent to the gas burner of the surface engineering flame at a distance from the gas burner to deposit a thin film layer (e.g., a silicon-containing and/or a phosphorus-containing thin film) onto the surface of the metal substrate. In some cases, the metal substrate can be passed through the deposition flame. As mentioned above, the distance between the metal surface and the burner of the surface engineering flame is also referred to herein as the frontal distance. The frontal distance can impact the structure of a thin film layer deposited onto the substrate. The frontal distance can be controlled by mechanical controls, computer controls, pneumatic controls, hydraulic controls, or any suitable position control system on the burner. The frontal distance can be adjusted according to burner design and desired process parameters. The frontal distance can be from about 8 millimeters (mm) to about 40 mm from a face of the burner (e.g., from about 15 mm to about 35 mm, from about 20 mm to about 35 mm, or from about 25 mm to about 30 mm). In some cases, the frontal distance can be about 8 mm, about 9 mm, about 10 mm, about 11 mm, about 12 mm, about 13 mm, about 14 mm, about 15 mm, about 16 mm, about 17 mm, about 18 mm, about 19 mm, about 20 mm, about 21 mm, about 22 mm, about 23 mm, about 24 mm, about 25 mm, about 26 mm, about 27 mm, about 28 mm, about 29 mm, about 30 mm, about 31 mm, about 32 mm, about 33 mm, about 34 mm, about 35 mm, about 36 mm, about 37 mm, about 38 mm, about 39 mm, about 40 mm, or anywhere in between.

The gas burner can be located in a process chamber. The process chamber can include a plurality of burners such that thin film deposition can occur on at least one surface of the metal substrate and can also occur on a second surface, a third surface, and/or a fourth surface of the metal substrate (e.g., an entirety of the metal substrate can undergo thin film deposition). The process chamber can also include a process gas delivery system, an environmental control system, an exhaust system, and a heat extraction system. The gas delivery system can optionally be placed outside the process chamber. In some examples, a plurality of process chambers can be linked together to allow for engineering of films to specific applications. For example, the plurality of process chambers can provide a layer-by-layer thin film deposition to provide engineered metal surfaces. In some aspects, the layer-by-layer process of depositing a thin film can include a cleaning step to remove surface contaminants, a step of depositing a silicon-containing and/or a phosphorus-containing thin film containing a corrosion inhibitor directly on the metal substrate surface, and a step of depositing an adhesion promoter layer for improved adhesion of coatings onto the silicon-containing and/or phosphorus-containing thin film. The engineering of thin films can involve additional film applications to accommodate for faster line speeds, multilayer systems consisting of multi-density films, or alternating functional films.

### Coating/Painting

In certain aspects, the products created from the metals and methods described herein can be coated or painted. For example, the disclosed products can be Zn-phosphated and electrocoated (E-coated). The surface engineered substrates as described herein can have improved coating adhesion without the use of wet chemicals.

Optionally, exposure to non-depositing flames, such as the premixed laminar flame, can be used to increase surface energy of the metal substrate. Increased surface energy can improve adhesion properties in wet coatings (e.g., roll-coated paint and/or lacquer).

### Surface Engineered Metal Substrates:

Also described herein are surface engineered metal substrates. The surface engineered metal substrates include a metal substrate, as described herein, having at least a first surface. The surface engineered metal substrates also include a silicon-containing thin film deposited on the metal substrate. The silicon-containing thin film includes a silicate and a chemical additive. The silicon-containing thin film is an amorphous silicate (a-SiO_{X}). In some cases, the silicate is a compound including silicon, oxygen, aluminum, and/or carbon. Optionally, the silicate can be a nesosilicate, a sorosilicate, a cyclosilicate, an inosilicate, a phyllosilicate, or a tectosilicate. One or more additives are also included in the silicon-containing thin film. For example, the silicon-containing thin film can additionally include an adhesion promoter for downstream processing, including painting, zinc phosphating (Zn-P), electrocoating (E-coating), powder coating, laminating, and/or lacquering, to name a few. Optionally, the silicon-containing thin film can include an additive to improve bond durability in bonding processes, including resistive spot welding (RSW), friction stir welding (FSW), gas metal arc welding (GMAW), laser welding, and/or self-piercing riveting (SPR), among others.

In some examples, the thin film layer deposited according to methods described herein can include an oxoanion as the chemical additive to provide a doped a-SiOx film. In certain cases, the thin film layer can include a chromate, a molybdate, a vanadate, an antimonite, an arsenate, a tungstate, or any combination thereof. Doped a-SiO_{X} thin films can enhance adhesion and corrosion inhibition by forming chromate, molybdate, or vanadate protective layers in addition to the a-SiO_{X} adhesion promoter layer. In some aspects, the oxoanion protective layer can preferentially deposit adjacent to the metal substrate and the a-SiO_{X} layer can deposit onto the protective layer on a side opposite the metal substrate providing a multi-layer film for corrosion inhibition and adhesion promotion. Additionally, doping alumina and/or silica nanoparticles and/or chloride scavengers into the a-SiO_{X} thin film can aid in corrosion inhibition.

The silicon-containing thin film can be adhered directly to a first surface of the metal substrate. The silicon-containing thin film can optionally be adhered to one or more additional surfaces of the metal substrate. In some examples, the silicon-containing thin film can be deposited on a chemical additive containing layer that is directly attached to the metal substrate surface. The deposition order can be engineered to accomplish the desired resulting property from the surface engineering step. For example, a surface engineered metal substrate can be prepared such that a corrosion inhibitor is deposited onto the metal substrate surface before deposition of the silicon-containing film containing an additive such that a corrosion inhibiting layer is deposited directly on the metal substrate surface and the silicon-containing thin film is deposited on the corrosion inhibitor layer. The silicon-containing thin film can include, for example, an adhesion promoting additive, thus resulting in a metal substrate surface having corrosion resistance properties and adhesion promotion properties. In a further example, a corrosion inhibitor and the silicon-containing thin film can deposit simultaneously, providing an amalgamated film for corrosion resistance and adhesion improvement.

As described above, the surface engineered metal substrate is an aluminum alloy.

The aluminum alloy is a 7xxx series aluminum alloy provided in an F temper. In these cases, the thin film is a dense amorphous silicate thin film. As used herein and as further described below in the Examples, a dense amorphous silicate thin film refers to a thin film in contact with greater than 80% of the surface of the surface engineered metal substrate. For example, the dense amorphous silicate thin film can be in contact with greater than 80%, greater than 85%, greater than 90%, or greater than 95% (e.g., 100%) of the surface of the surface engineered metal substrate.

### Methods of Using:

The metals and methods described herein can be used in automotive, electronics, architectural, and transportation applications, such as commercial vehicle, aircraft, or railway applications, or other applications.

In certain aspects, the metals and methods can be used to prepare motor vehicle body part products. For example, the disclosed metals and methods can be used to prepare automobile body parts, such as bumper beams, side beams, roof beams, cross beams, pillar reinforcements (e.g., A-pillars, B-pillars, and C-pillars), inner panels, side panels, floor panels, tunnels, structure panels, reinforcement panels, inner hoods, or trunk lid panels. The disclosed metals and methods can also be used in aircraft or railway vehicle applications, to prepare, for example, external and internal panels. The surface engineered metals as described herein can improve durability of bonded joints in vehicle manufacturing and other applications requiring bonded metal parts. The surface engineered metals described herein can be used for aesthetic parts including automotive door panels, hoods, trunk lids, architectural panels, and other consumer facing metal panels.

The described metals and methods can also be used to prepare housings for electronic devices, including mobile phones and tablet computers. For example, the metals can be used to prepare housings for the outer casing of mobile phones (e.g., smart phones) and tablet bottom chassis, with or without electrolytic oxidation. Exemplary consumer electronic products include mobile phones, audio devices, video devices, cameras, laptop computers, desktop computers, tablet computers, televisions, displays, household appliances, video playback and recording devices, and the like. Exemplary consumer electronic product parts include outer housings (e.g., facades) and inner pieces for the consumer electronic products. The surface engineered metals as described herein can be electrically insulatory (e.g., when the metals are electrolytically oxidized before surface engineering), resistant to corrosion, and amenable to coatings.

The following examples will serve to further illustrate the present invention without, however, constituting any limitation thereof. During the studies described in the following examples, conventional procedures were followed, unless otherwise stated. Some of the procedures are described below for illustrative purposes.

### EXAMPLES

### Example 1: Coil-to-Coil Flame Pyrolysis Surface Engineering

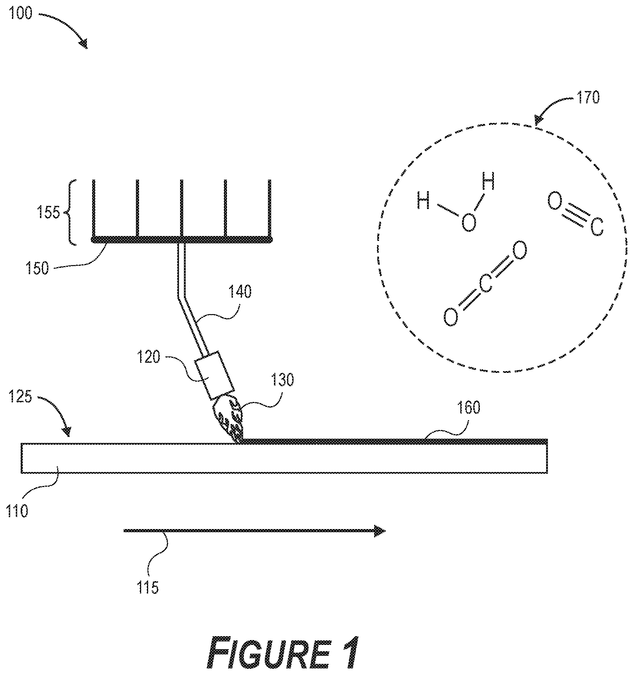

Figure 1 is a schematic of a surface engineering method 100 as described herein. A metal substrate 110 is passed in direction 115 adjacent to a burner 120 such that at least one surface 125 of the metal substrate 110 contacts a laminar flame 130. Process gases are supplied through a primary supply line 140 connected to a manifold 150 capable of supplying a plurality of process gases *via* individual supply lines 155. The individual supply lines 155 and the primary supply line 140 can include gas flow control devices (e.g., a mass flow controller, a computer controlled valve, or a ball valve). The individual supply lines 155 and manifold 150 can premix the process gases before feeding the process gases to the burner 120. The burner 120 supplies the laminar flame 130 for the thin film deposition. A flame pyrolysis reaction of the process gases can occur in the laminar flame 130 and can deposit a film 160 onto the at least one surface 125 of the metal substrate 110. In some examples, the reaction byproducts 170 of the flame pyrolysis reaction can include carbon monoxide, carbon dioxide, water vapor, silicon and/or silicate dust (not shown), and/or phosphate dust (not shown).

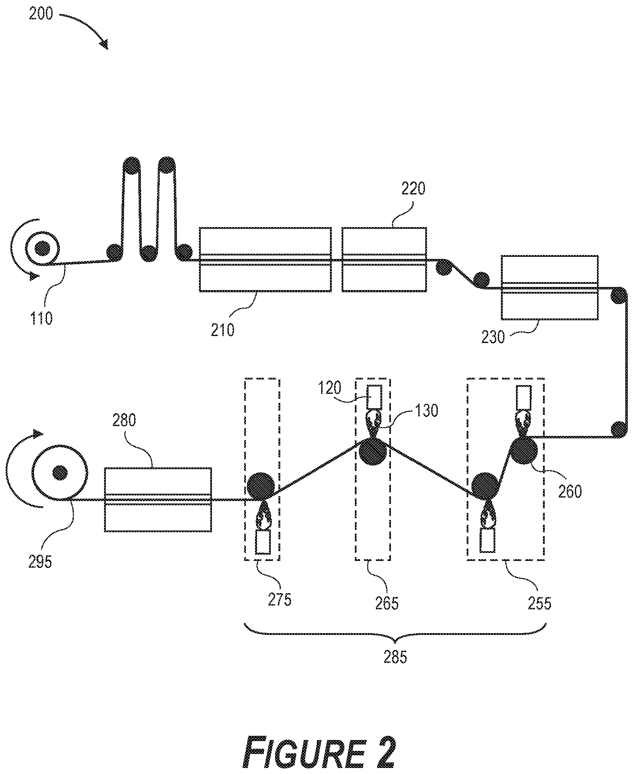

Figure 2 is a schematic of an exemplary surface engineering method 100 as described herein employed in a coil-to-coil finishing line 200. An aluminum alloy coil is uncoiled and the metal substrate 110 is fed through a solutionizing furnace 210 for solution heat treatment and through a quenching chamber 220 for quenching. The metal substrate 110 is then cleaned in a cleaning process chamber 230 to remove residual oils and excessive metal oxide species from the surface(s) of the metal substrate 110. Optionally, residual oils can be removed from a first surface and a second surface of the metal substrate 110 (e.g., a top surface and a bottom surface can be cleaned). In some aspects, all surfaces of the metal substrate 110 are cleaned (e.g., the top surface, the bottom surface, a first side, and a second side are cleaned). At least a first surface of the metal substrate 110 is then engineered according to methods described herein. The metal substrate 110 can be passed through a surface engineering processing chamber 255 equipped with a plurality of burners 120 such that the first surface (e.g., the top surface) and the second surface (e.g., the bottom surface) can be engineered simultaneously. Rollers 260 can guide the metal substrate 110 adjacent to the laminar flame 130 such that a pyrolyzed precursor, fuel, and air mixture can deposit a film 160 *(see* Figure 1) onto the metal substrate 110. Any reaction byproducts 170 (*see* Figure 1) produced by pyrolysis can be removed from the surface engineering process chamber 255 by an exhaust system (not shown). The exhaust system can control atmospheric conditions inside the process chamber by extracting heat produced by the methods described herein. In some cases, the exhaust system can be employed to control the laminar flame 130. Engineering at least the first surface of the metal substrate 110 and a second surface simultaneously can include applying at least a first thin film on the first surface and the first thin film on the second surface. Optionally, engineering at least the first surface of the metal substrate 110 and second surface simultaneously can include applying the first thin film on the first surface and a second thin film on the second surface.

In some examples, the metal substrate 110 can be passed through a surface engineering processing chamber 265 equipped with one or more burners 120 such that one surface (e.g., a first surface, a top surface, or an interior surface of the coil when coiled) can be engineered. In some further examples, the metal substrate 110 can be passed through a surface engineering processing chamber 275 equipped with one or more burners 120 such that one surface (e.g., a second surface, a bottom surface, or an exterior surface of the coil when coiled) can be surface engineered.

In some further examples, the metal substrate 110 can be passed through a plurality of surface engineering processing chambers 285 such that at least a first film can be applied to the first surface. Optionally, each surface engineering processing chamber included in the plurality of surface engineering processing chambers 285 can include at least a burner 120 and can further include a plurality of burners 120 such that multi-layer films, multi-density films, and multifunctional films can be engineered and deposited. Additionally, employing a plurality of surface engineering processing chambers 285 and/or a plurality of burners 120 can improve speed and efficiency of a coil-to-coil finishing line 200.

The metal substrate 110 can be lubricated after surface engineering. The metal substrate 110 can pass through a lubrication chamber 280 where lubricant is applied to the metal substrate 110. Lubricant application can be performed by spraying, roll coating, immersion coating, any combination thereof or any suitable lubricant coating technique known to one of skill in the art. In some examples, the metal substrate is recoiled providing a surface engineered aluminum alloy coil 295.

### Example 2: Effect of Dry Surface Engineering on Coating Applications

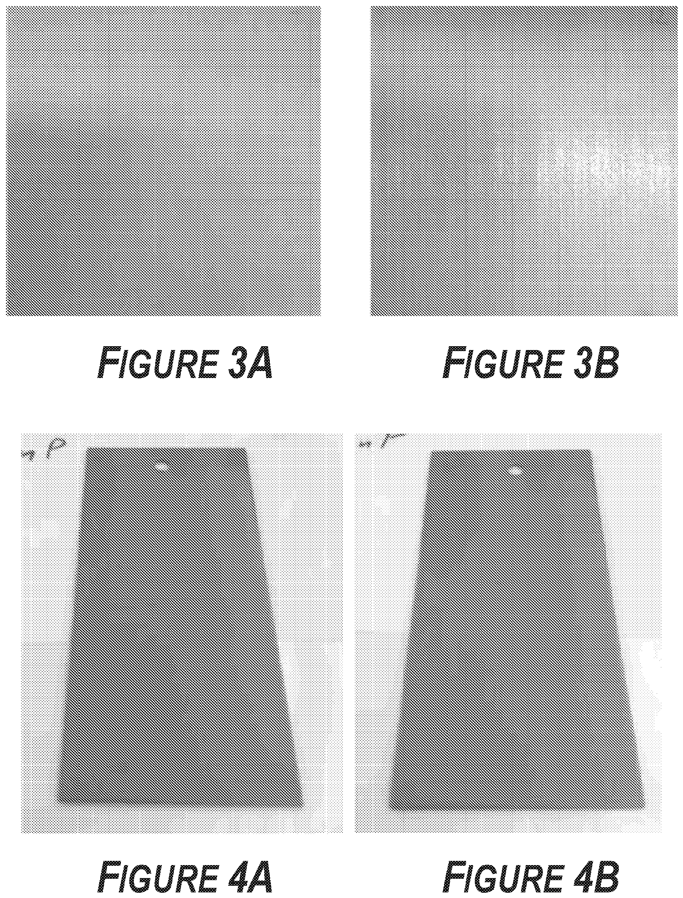

Figures 3A-3B and 4A-4B illustrate coating uniformity of surface engineered aluminum alloys as described herein. Figure 3A shows an amorphous silicate (a-SiO_{X}) film containing aluminum alloy subjected to zinc phosphating. Evident in the image is a uniform zinc phosphate (Zn-P) film acceptable to original equipment manufacturers (OEMs). Figure 3B shows an aluminum alloy sample prepared with non-optimal surface engineering parameters. Evident in the image is a non-uniform Zn-P coating exhibiting effects of surface engineering method parameters on the Zn-P film.

Figures 4A-4B show aluminum alloy samples subjected to Zn-P and electrocoating (E-coating). Figure 4A shows an amorphous silicate (a-SiO_{X}) surface engineered aluminum alloy subjected to zinc phosphating (Zn-P) and E-coating. Optimal a-SiO_{X} surface engineering parameters were employed providing a uniform film. Figure 4B shows an a-SiO_{X} surface engineered aluminum alloy sample subjected to Zn-P and E-coating. Non-optimal a-SiO_{X} surface engineering parameters were employed providing a non-uniform Zn-P film; however, the E-coating process obscures any non-uniformity observed in the Zn-P layer.

### Example 3: Effect of Thin Films on Bond Durability and Corrosion

Aluminum alloy substrates subjected to dry surface engineering methods as described herein were bonded and subjected to a bond durability test. During bond durability testing, bonds are created between two aluminum alloy products, such as by an epoxy adhesive. Then, the bonded aluminum alloy products are subjected to strain and/or other conditions. For example, the bonded alloy products may be immersed in a salt solution, subject to humid conditions, or drying conditions. After a series of cycles in one or more conditions, the bonds between the aluminum alloys are evaluated for chemical and mechanical failure. Table 1 presents results of a bond durability test performed on AA5754 aluminum alloy samples:

**Table 1**

| **Sample** | **Air:Gas ratio** | **Frontal Distance (mm)** | **Flow Rate (sccm)** | **Experiment No. (cycles to failure)** | | | | | | **Residual Strength (kN)** |
|---|---|---|---|---|---|---|---|---|---|---|
| | | | | 1 | **2** | **3** | **4** | **5** | **6** | |
| 1 | 8 | 23 | 2000 | 60 | 60 | 60 | 60 | 60 | 60 | 5889 |
| 2 | 8 | 23 | 3000 | 60 | 60 | 60 | 60 | 60 | 60 | 5793 |
| 3 | 10 | 23 | 2000 | 60 | 60 | 60 | 60 | 60 | 60 | 5837 |
| 4 | 10 | 23 | 3000 | 60 | 60 | 60 | 58 | 60 | 60 | 5505 |
| 5 | 8 | 20 | 2000 | 60 | 60 | 60 | 60 | 60 | 60 | 5235 |
| 6 | 8 | 20 | 3000 | 60 | 60 | 60 | 60 | 60 | 60 | 6074 |
| 7 | 10 | 20 | 2000 | 60 | 60 | 60 | 60 | 60 | 60 | 5191 |
| 8 | 10 | 20 | 3000 | 60 | 60 | 60 | 60 | 60 | 34 | 6134 |

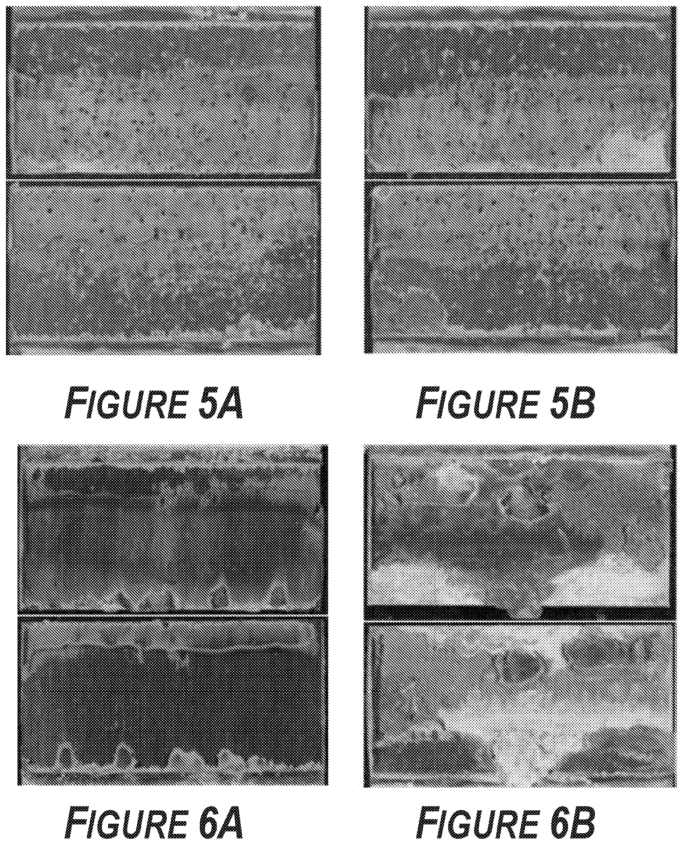

A sample surviving 45 cycles is considered to pass. Figures 5A-5B show digital images of Sample 2 after Experiment No. 1 from Table 1 (Figure 5A) and after Experiment No. 6 from Table 1 (Figure 5B). The samples exhibited signs of cohesive failure, indicating the failure mechanism was a failure of the adhesive and was not due to the bonding of the adhesive to the aluminum alloy substrate. This result further demonstrates the success of the amorphous silicate thin film as an adhesion promoter.

Evidence of corrosion initiation was observed on each sample, indicating good resistance to corrosion propagation. Observed corrosion initiation without corrosion propagation can indicate that the amorphous silicate thin film improved corrosion resistance. Figures 6A-6B show digital images of Sample 8 after Experiment No. 1 from Table 1 (Figure 6A) and Experiment No. 6 from Table 1 (Figure 6B). The samples exhibited signs of adhesive failure, indicating the failure mechanism was failure due to the bonding of the adhesive to the aluminum alloy substrate. All samples exhibited resistance to corrosion after 60 cycles of the corrosion test.

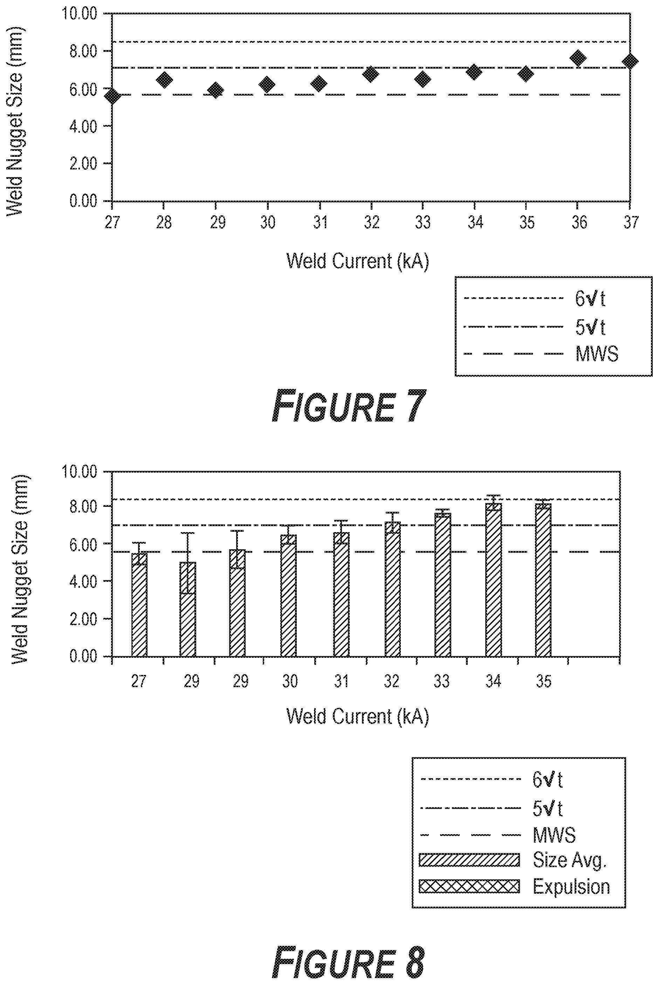

Surface engineered alloys as described herein and a comparative alloy were subjected to resistive spot welding (RSW) testing. Figure 7 presents RSW data for a non-surface engineered aluminum alloy. The non-surface engineered aluminum alloy was welded under 1000 lb-ft of clamping force with a weld dwell time of 133 milliseconds (ms). The weld nugget size is shown as a function of weld current. The weld current ranged from 27 kA to 37 kA. Minimum weld size (MWS) of 4√T is indicated by a large dashed line. Optional weld sizes of 5√T (small dashed line) and 6√T (dotted line) are also indicated.

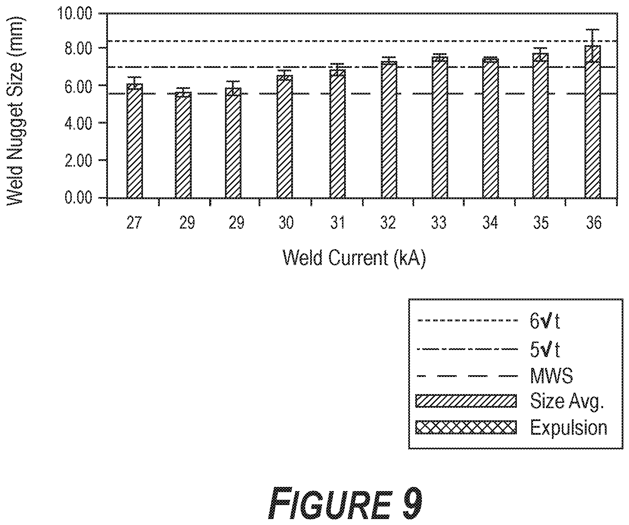

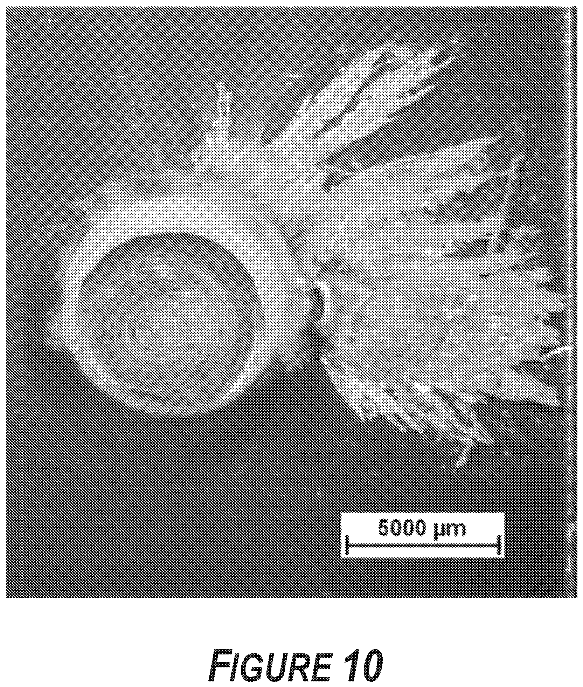

Figures 8 and 9 present RSW data for aluminum alloy samples prepared according to methods described herein. For illustrative purposes, a weld expulsion is shown in Figure 10. The weld parameters for the alloy sample shown in Figure 8 were identical to the weld parameters for the comparative non-surface engineered aluminum alloy (clamping force was 1000 lb-ft, weld current ranged from 27 kA to 35kA, and weld dwell time was 133 ms). The weld parameters for the alloy sample shown in Figure 9 were optimized for aluminum alloys surface engineered with an amorphous silicate thin film (clamping force was increased to 1200 lb-ft, weld current ranged from 27 kA to 36kA, and weld dwell time was 133 ms). The data and observations (e.g., excellent tear down efficiency and no weld expulsions) indicate that successful joining (e.g., RSW) can be performed on aluminum alloys subjected to the dry surface engineering process as described herein.

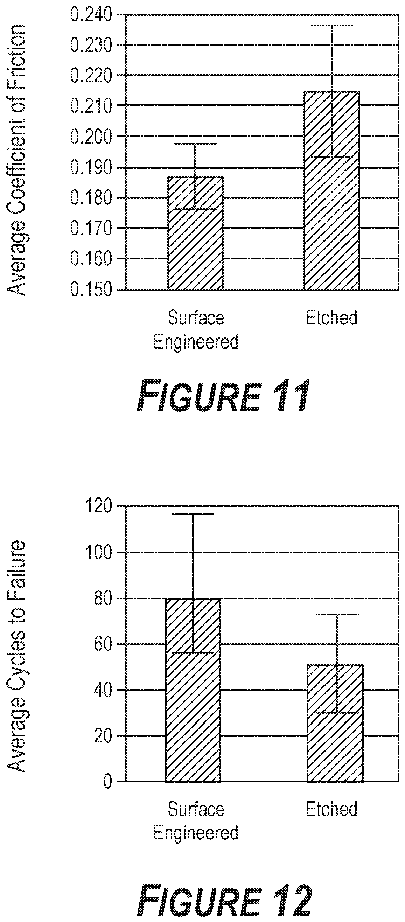

Figures 11 and 12 present cylinder-on-flat friction test results for surface engineered aluminum alloys prepared according to methods described herein and also for non-surface engineered alloys. In Figure 11, an exemplary surface engineered alloy (referred to as "surface engineered," left histogram) and a comparative cleaned and non-surface engineered aluminum alloy (referred to as "etched," right histogram) were subjected to the cylinder-on-flat friction test and evaluated for coefficient of friction. The exemplary surface engineered aluminum alloy exhibited a lower coefficient of friction. Figure 12 presents average cycles to failure for an exemplary surface engineered alloy (referred to as "surface engineered," left histogram) and a comparative cleaned and non-surface engineered aluminum alloy (referred to as "etched," right histogram) that were subjected to the cylinder-on-flat friction test. The exemplary surface engineered aluminum alloy was able to withstand more cycles before failure than the comparative non-surface engineered aluminum alloy.

An AA7075 aluminum alloy was used in Samples 9 - 13 of Table 2. Sample 9 is an AA7075 aluminum alloy provided in T6 temper by heating the aluminum alloy to 485 °C and maintaining the temperature for five minutes, then reducing the temperature to 125 °C and maintaining the temperature for 24 hours. Samples 10-13 are AA7075 aluminum alloys provided in F temper. Sample 9 demonstrates surface engineering aluminum alloys in a downstream manufacturing process, e.g., surface engineering that is performed after an artificial aging step or a forming step following casting, homogenizing, hot rolling, optional cold rolling, optional solution heat treating, and optional quenching. Samples 10 - 13 demonstrate surface engineering as-fabricated aluminum alloys, e.g., surface engineering an aluminum alloy coil provided after casting, homogenizing, hot rolling, optional cold rolling, and optional solution heat treating. The surface engineering conditions are shown in Table 2. Additionally, the air flow for samples 9 - 13 was 150 cubic centimeters per minute (cc/min), and Samples 9 - 13 were passed under a single burner four times to ensure the entire aluminum alloy surface was surface engineered (i.e., coated with the amorphous silicate thin film). Sample 9 was surface engineered at a frontal distance of 30 mm. Samples 10 - 13 were surface engineered at various frontal distances ranging from 15 - 30 mm, as indicated in Table 2 below. Prior to bond durability testing, samples 10-13 were provided in T6 temper by heating the aluminum alloy to 485 °C and maintaining the temperature for five minutes, then reducing the temperature to 125 °C and maintaining the temperature for 24 hours. After aging, a coupling agent (e.g., a coupling agent/sealant) was applied to heated samples within four hours before bonding. Results from bond durability testing performed at 90 % relative humidity (RH) are shown in Table 2 below:

**Table 2**

| **Sample** | **Air:Gas ratio** | **Frontal Distance (mm)** | **Flow Rate (sccm)** | **Experiment No. (cvcles to failure)** | | | | | |
|---|---|---|---|---|---|---|---|---|---|
| | | | | **1** | **2** | **3** | **4** | **5** | **6** |
| 9 | 9 | 25 | 2500 | 2 | 4 | 4 | 4 | 4 | 4 |
| 10 | 9 | 15 | 2500 | 60 | 60 | 59 | 60 | 59 | 60 |
| 11 | 9 | 20 | 2500 | 52 | 52 | 49 | 48 | 52 | 50 |
| 12 | 9 | 25 | 2500 | 51 | 44 | 50 | 49 | 51 | 51 |
| 13 | 9 | 30 | 2500 | 57 | 52 | 57 | 50 | 57 | 56 |

A sample surviving 45 cycles is considered to pass. As shown in Table 2, surface engineering aluminum alloys in F temper demonstrated markedly improved bond durability when compared to surface engineering aluminum alloys in T6 temper. Thus, surface engineering as-fabricated aluminum alloys can greatly improve the bond durability of final products produced from the surface engineered aluminum alloys.

As described above, the degree of contact of the thin film with the surface of the substrate (e.g., aluminum alloy substrate) can vary based on the temper of the sample. Sample 9, provided in T6 temper before the surface engineering step, can exhibit an incomplete amorphous silicate thin film on the surface of the aluminum alloy. For example, the incomplete amorphous silicate thin film can only partially covered the surface of the aluminum alloy (e.g., only up to about 80% of the surface of the aluminum alloy can be covered with the amorphous silicate thin film). Conversely, each sample provided in F temper can exhibit a complete and dense amorphous silicate thin film covering the entire aluminum alloy surface (e.g., greater than 80%, such as 100%, of the aluminum alloy surface was covered with the amorphous silicate thin film). The thin film morphology and degree of coverage can apply for films of various thicknesses, including films having a thickness in the ranges described above. Thus, certain heat treating processes (e.g., hot forming, artificial aging, and the like) can provide a particulate amorphous silicate thin film to the aluminum alloy surface. Further, surface engineering an as-fabricated aluminum alloy (e.g., an F temper aluminum alloy) can provide a dense and uniform amorphous silicate thin film that, in some instances, can completely cover the aluminum alloy surface.

Various embodiments of the invention have been described in fulfillment of the various objectives of the invention. It should be recognized that these embodiments are merely illustrative of the principles of the present invention. Numerous modifications and adaptions thereof will be readily apparent to those skilled in the art without departing from scope of the present invention as defined in the following claims.

## Claims

1. A method of engineering a metal substrate surface, comprising:
combining an oxidizer and a combustible gas to form a gas mixture, wherein the combustible gas comprises natural gas, methane, propane, butane, or a combination thereof;
igniting the gas mixture to form a premixed laminar flame;
feeding a chemical precursor and a chemical additive into the premixed laminar flame to form a surface engineering flame, wherein the chemical precursor comprises a silicon-containing compound;
directing the surface engineering flame onto the metal substrate surface,
wherein a thin film is deposited onto the metal substrate surface, wherein the thin film is a dense amorphous silicate thin film in contact with greater than 80% of the surface or the surface engineered metal substrate,
wherein the surface engineered metal substrate is a 1xxx series aluminum alloy, a 2xxx series aluminum alloy, a 3xxx series aluminum alloy, a 4xxx series aluminum alloy, a 5xxx series aluminum alloy, a 6xxx series aluminum alloy, 7xxx series aluminum alloy, or an 8xxx series aluminum alloy,
wherein the aluminum alloy is provided in an F temper,
and wherein the oxidizer and the combustible gas are present in the gas mixture in a molar ratio of from 1:1 to 10:1.

2. The method of claim 1, further comprising cleaning the metal substrate surface prior to the directing step.

3. The method of claim 2, wherein the cleaning is performed by directing a flame onto the metal substrate surface, wherein the flame is the premixed laminar flame; or
wherein the cleaning is performed using a chemical etching process, an electrolytic cleaning process, or an ultrasonic cleaning process.

4. The method of any of claims 1-3, wherein the chemical precursor or the chemical additive is fed into the premixed laminar flame at a flow rate of from about 500 mL/min to about 5000 mL/min.

5. The method of any of claims 1-4, wherein the metal substrate surface is maintained at a distance from a burner of the surface engineering flame; and in particular wherein the distance is from about 8 mm to about 40 mm.

6. The method of any of claims 1-5, wherein the silicon-containing compound comprises hexamethyldisiloxane (HMDSO), tetramethylsilane (TMS), tetraethoxysilane (TEOS), triethoxysilane, N-sec-butyl(trimethylsilyl)amine, 1,3-diethyl-1,1,3,3,tetramethyldisilazane, methylsilane, pentamethyldisilane, tetraethylsilane, tetramethyldisilane, or a combination thereof.

7. The method of any of claims 1-6, further comprising electrolytically oxidizing the metal substrate surface prior to the directing step.

8. The method of any of claims 1-7, wherein the surface engineered metal substrate is a 7xxx series aluminum alloy in an F temper.

9. A surface engineered metal substrate obtainable by the method according to any one of claims 1-8 comprising:
a surface; and
a thin film, wherein the thin film comprises a silicon-containing compound and a chemical additive, and wherein the surface engineered metal substrate is a 7xxx series aluminum alloy in an F temper and the thin film is a dense amorphous silicate thin film in contact with greater than 80% of the surface or the surface engineered metal substrate.

10. The surface engineered metal substrate of claim 9, further comprising a thin electrolytic oxidized layer.

11. Use of a surface engineered metal substrate obtainable by the method of any of claims 1-8 in automotive and transportation applications, wherein the surface engineered metal substrate comprises:
a surface; and
a thin film, wherein the thin film comprises a silicon-containing compound and a chemical additive, wherein the thin film is a dense amorphous silicate thin film in contact with greater than 80% of the surface or the surface engineered metal substrate,
wherein the surface engineered metal substrate is a 1xxx series aluminum alloy, a 2xxx series aluminum alloy, a 3xxx series aluminum alloy, a 4xxx series aluminum alloy, a 5xxx series aluminum alloy, a 6xxx series aluminum alloy, 7xxx series aluminum alloy, or an 8xxx series aluminum alloy, and
wherein the aluminum alloy is in an F temper.

12. The use of a surface engineered metal substrate according to claim 11, wherein the surface engineered metal substrate further comprises a thin electrolytic oxidized layer.

13. The use of a surface engineered metal substrate according to claim 11, wherein the surface engineered metal substrate is a 7xxx series aluminum alloy in an F temper.

## Patentansprüche

1. Verfahren zur Behandlung einer Metallsubstratoberfläche, umfassend:
Kombinieren eines Oxidationsmittels und eines brennbaren Gases, um ein Gasgemisch zu bilden, wobei das brennbare Gas Erdgas, Methan, Propan, Butan oder eine Kombination davon umfasst;
Zünden des Gasgemischs, um eine vorgemischte laminare Flamme zu bilden;
Einleiten eines chemischen Vorläufers und eines chemischen Additivs in die vorgemischte laminare Flamme, um eine Oberflächenbehandlungsflamme zu bilden, wobei der chemische Vorläufer eine siliciumhaltige Verbindung umfasst;
Richten der Oberflächenbehandlungsflamme auf die Metallsubstratoberfläche,
wobei ein dünner Film auf die Metallsubstratoberfläche aufgetragen wird, wobei der dünne Film ein dichter amorpher Silikatdünnfilm ist, der mit mehr als 80 % der Oberfläche oder des oberflächenbehandelten Metallsubstrats in Kontakt steht,
wobei das oberflächenbehandelte Metallsubstrat eine Aluminiumlegierung der 1xxx-Serie, eine Aluminiumlegierung der 2xxx-Serie, eine Aluminiumlegierung der 3xxx-Serie, eine Aluminiumlegierung der 4xxx-Serie, eine Aluminiumlegierung der 5xxx-Serie, eine Aluminiumlegierung der 6xxx-Serie, Aluminiumlegierung der 7xxx-Serie oder eine Aluminiumlegierung der 8xxx-Serie ist,
wobei die Aluminiumlegierung in einem F-Zustand bereitgestellt wird,
und wobei das Oxidationsmittel und das brennbare Gas in dem Gasgemisch in einem molaren Verhältnis von 1:1 bis 10:1 vorliegen.

2. Verfahren nach Anspruch 1, ferner umfassend Reinigen der Metallsubstratoberfläche vor dem Schritt des Richtens.

3. Verfahren nach Anspruch 2, wobei das Reinigen durch Richten einer Flamme auf die Metallsubstratoberfläche durchgeführt wird, wobei die Flamme die vorgemischte laminare Flamme ist; oder
wobei das Reinigen unter Verwendung eines chemischen Ätzprozesses, eines elektrolytischen Reinigungsprozesses oder eines Ultraschallreinigungsprozesses durchgeführt wird.

4. Verfahren nach einem der Ansprüche 1-3, wobei der chemische Vorläufer oder das chemische Additiv der vorgemischten laminaren Flamme mit einer Flussrate von etwa 500 ml/min bis etwa 5000 ml/min zugeführt wird.

5. Verfahren nach einem der Ansprüche 1-4, wobei die Metallsubstratoberfläche in einem Abstand von einem Brenner der Oberflächenbehandlungsflamme gehalten wird; und insbesondere
wobei der Abstand etwa 8 mm bis etwa 40 mm beträgt.

6. Verfahren nach einem der Ansprüche 1-5, wobei die siliciumhaltige Verbindung Hexamethyldisiloxan (HMDSO), Tetramethylsilan (TMS), Tetraethoxysilan (TEOS), Triethoxysilan, N-sec-Butyl(trimethylsilyl)amin, 1,3-Diethyl-1,1,3,3-tetramethyldisilazan, Methylsilan, Pentamethyldisilan, Tetraethylsilan, Tetramethyldisilan oder eine Kombination davon umfasst.

7. Verfahren nach einem der Ansprüche 1-6, ferner umfassend elektrolytisches Oxidieren der Metallsubstratoberfläche vor dem Schritt des Richtens.

8. Verfahren nach einem der Ansprüche 1-7, wobei das oberflächenbehandelte Metallsubstrat eine Aluminiumlegierung der 7xxx-Serie in einem F-Zustand ist.

9. Oberflächenbehandeltes Metallsubstrat erhältlich durch das Verfahren nach einem der Ansprüche 1-8, umfassend:
eine Oberfläche; und
einen dünnen Film, wobei der dünne Film eine siliciumhaltige Verbindung und ein chemisches Additiv umfasst, und wobei das oberflächenbehandelte Metallsubstrat eine Aluminiumlegierung der 7xxx-Serie in einem F-Zustand ist und der dünne Film ein dichter amorpher Silikatdünnfilm ist, der mit mehr als 80 % der Oberfläche oder des oberflächenbehandelten Metallsubstrats in Kontakt steht.

10. Oberflächenbehandeltes Metallsubstrat nach Anspruch 9, ferner umfassend eine dünne elektrolytisch oxidierte Schicht.

11. Verwendung eines oberflächenbehandelten Metallsubstrats erhältlich durch das Verfahren nach einem der Ansprüche 1-8 in Automobil- und Transportanwendungen, wobei das oberflächenbehandelte Metallsubstrat umfasst:
eine Oberfläche; und
einen dünnen Film, wobei der dünne Film eine siliciumhaltige Verbindung und ein chemisches Additiv umfasst, wobei der dünne Film ein dichter amorpher Silikatdünnfilm ist, der mit mehr als 80 % der Oberfläche oder des oberflächenbehandelten Metallsubstrats in Kontakt steht,
wobei das oberflächenbehandelte Metallsubstrat eine Aluminiumlegierung der 1xxx-Serie, eine Aluminiumlegierung der 2xxx-Serie, eine Aluminiumlegierung der 3xxx-Serie, eine Aluminiumlegierung der 4xxx-Serie, eine Aluminiumlegierung der 5xxx-Serie, eine Aluminiumlegierung der 6xxx-Serie, Aluminiumlegierung der 7xxx-Serie oder eine Aluminiumlegierung der 8xxx-Serie ist, und
wobei die Aluminiumlegierung in einem F-Zustand vorliegt.

12. Verwendung eines oberflächenbehandelten Metallsubstrats nach Anspruch 11, wobei das oberflächenbehandelte Metallsubstrat ferner eine dünne elektrolytisch oxidierte Schicht umfasst.

13. Verwendung eines oberflächenbehandelten Metallsubstrats nach Anspruch 11, wobei das oberflächenbehandelte Metallsubstrat eine Aluminiumlegierung der 7xxx-Serie in einem F-Zustand ist.

## Revendications

1. Procédé de modification de la surface d'un substrat métallique, consistant à :
combiner un oxydant et un gaz combustible pour former un mélange gazeux, le gaz combustible comprenant du gaz naturel, du méthane, du propane, du butane ou une combinaison de ceux-ci ;
enflammer le mélange gazeux pour former une flamme laminaire pré-mélangée ;
introduire un précurseur chimique et un additif chimique dans la flamme laminaire pré-mélangée pour former une flamme de modification de surface, le précurseur chimique comprenant un composé contenant du silicium ;
diriger la flamme de modification de surface sur la surface du substrat métallique,
dans lequel
un film mince est déposé sur la surface du substrat métallique, le film mince étant un film mince de silicate amorphe dense en contact avec plus de 80 % de la surface ou du substrat métallique à surface modifiée,
le substrat métallique à surface modifiée est un alliage d'aluminium de la série 1xxx, un alliage d'aluminium de la série 2xxx, un alliage d'aluminium de la série 3xxx, un alliage d'aluminium de la série 4xxx, un alliage d'aluminium de la série 5xxx, un alliage d'aluminium de la série 6xxx, un alliage d'aluminium de la série 7xxx, ou un alliage d'aluminium de la série 8xxx,
l'alliage d'aluminium est fourni dans un état F,
et l'oxydant et le gaz combustible sont présents dans le mélange gazeux dans un rapport molaire de 1:1 à 10:1.

2. Procédé selon la revendication 1, consistant en outre à nettoyer la surface du substrat métallique avant d'y diriger la flamme de modification de surface.

3. Procédé selon la revendication 2,
dans lequel le nettoyage est effectué en dirigeant une flamme sur la surface du substrat métallique, la flamme étant la flamme laminaire pré-mélangée ; ou
le nettoyage est effectué à l'aide d'un procédé de gravure chimique, d'un procédé de nettoyage électrolytique ou d'un procédé de nettoyage par ultrasons.

4. Procédé selon l'une des revendications 1 à 3,
dans lequel le précurseur chimique ou l'additif chimique est introduit dans la flamme laminaire pré-mélangée à un débit d'environ 500 ml/min à environ 5 000 ml/min.

5. Procédé selon l'une des revendications 1 à 4,
dans lequel la surface du substrat métallique est maintenue à une certaine distance d'un brûleur de la flamme de modification de surface ; et
en particulier, la distance est d'environ 8 mm à environ 40 mm.

6. Procédé selon l'une des revendications 1 à 5,
dans lequel le composé contenant du silicium comprend hexaméthyldisiloxane (HMDSO), tétraméthylsilane (TMS), tétraéthoxysilane (TEOS), triéthoxysilane, N-sec-butyl(triméthylsilyl)amine, 1,3-diéthyl-1,1,3,3, tétraméthyldisilazane, méthylsilane, pentaméthyldisilane, tétraéthylsilane, tétraméthyldisilane, ou une combinaison de ceux-ci.

7. Procédé selon l'une des revendications 1 à 6, consistant en outre à faire oxyder électrolytiquement la surface du substrat métallique avant d'y diriger la flamme de modification de surface.

8. Procédé selon l'une des revendications 1 à 7,
dans lequel le substrat métallique à surface modifiée est un alliage d'aluminium de la série 7xxx à l'état F.

9. Substrat métallique à surface modifiée obtenu par le procédé selon l'une des revendications 1 à 8, comprenant :
une surface ; et
un film mince, le film mince comprenant un composé contenant du silicium et un additif chimique, et le substrat métallique à surface modifiée étant un alliage d'aluminium de la série 7xxx à l'état **F,** et le film mince étant un film mince de silicate amorphe dense en contact avec plus de 80 % de la surface ou du substrat métallique à surface modifiée.

10. Substrat métallique à surface modifiée selon la revendication 9, comprenant en outre une fine couche oxydée électrolytiquement.

11. Utilisation d'un substrat métallique à surface modifiée obtenu par le procédé selon l'une des revendications 1 à 8 dans des applications automobiles et de transport,
dans laquelle le substrat métallique à surface modifiée comprend :
une surface ; et
un film mince, le film mince comprenant un composé contenant du silicium et un additif chimique, le film mince étant un film mince de silicate amorphe dense en contact avec plus de 80 % de la surface ou du substrat métallique à surface modifiée,
le substrat métallique à surface modifiée est un alliage d'aluminium de la série 1xxx, un alliage d'aluminium de la série 2xxx, un alliage d'aluminium de la série 3xxx, un alliage d'aluminium de la série 4xxx, un alliage d'aluminium de la série 5xxx, un alliage d'aluminium de la série 6xxx, un alliage d'aluminium de la série 7xxx, ou un alliage d'aluminium de la série 8xxx, et l'alliage d'aluminium est à l'état F.

12. Utilisation d'un substrat métallique à surface modifiée selon la revendication 11,
dans laquelle le substrat métallique à surface modifiée comprend en outre une fine couche oxydée électrolytiquement.

13. Utilisation d'un substrat métallique à surface modifiée selon la revendication 11,
dans laquelle le substrat métallique à surface modifiée est un alliage d'aluminium de la série 7xxx à l'état F.
